# EUROPEAN PATENT SPECIFICATION

(11) **EP 3 844 318 B1**
(45) Date of publication and mention of the grant of the patent: **10.12.2025**
(21) Application number: 19869361.6
(22) Date of filing: 02.10.2019
(51) Int. Cl.: H01L 21/02, C23C 16/455, C23C 16/34, C23C 16/56, C23C 16/36, C23C 16/505, C07F 7/12

(54) **METHODS FOR MAKING SILICON AND NITROGEN CONTAINING FILMS**
VERFAHREN ZUR HERSTELLUNG VON SILICIUM- UND STICKSTOFFHALTIGEN SCHICHTEN
PROCÉDÉS DE FABRICATION DE FILMS CONTENANT DU SILICIUM ET DE L'AZOTE

(30) Priority: 03.10.2018 US 201862740478 P
(43) Date of publication of application: 07.07.2021
(73) Proprietor: Versum Materials US, LLC, Tempe, AZ 85284 (US)
(72) Inventor: LEI, Xinjian, Tempe, AZ 85284 (US); KIM, Moo-sung, Tempe, AZ 85284 (US); LEE, Se-won, Tempe, AZ 85284 (US)
(74) Representative: Sommer, Andrea
(86) International application number: PCT/US2019/054268
(87) International publication number: WO 2020/072625

(56) References cited:
- WO-A1-2016/149541
- KR-A- 20180 010 994
- KR-A- 20180 034 581
- US-A1- 2002 082 438
- US-A1- 2011 256 734
- US-A1- 2013 078 376
- US-A1- 2018 033 614
- US-A1- 2018 033 614
- US-A1- 2019 249 296

## Description

### CROSS-REFERENCE TO RELATED APPLICATIONS

This application claims priority to U.S. provisional patent application No. 62/740,478, filed on October 3, 2018.

### FIELD OF THE INVENTION

The present invention is directed to compositions and methods for the fabrication of an electronic device. More specifically, the invention is directed to compounds, compositions and methods for the deposition of a low dielectric constant (< 6.0) and high oxygen ash resistant silicon-containing film such as, without limitation, a stoichiometric silicon nitride, a carbon-doped silicon nitride film, and a carbon-doped silicon oxynitride film.

### BACKGROUND OF THE INVENTION

Silicon nitride films are used in semiconductor for a variety of applications. For example, the silicon nitride film is used as a final passivation and mechanical protective layer for integrated circuits, a mask layer for selective oxidation of silicon, as one of the dielectric materials in a stacked oxide-nitride-oxide (O-N-O) layer in DRAM capacitor or in 3D NAND flash memory chips, or as a CMP stop layer in a shallow trench isolation application. In one particular application, O-N-O stack in 3D NAND flash requires silicon nitride with low stress and high wet etch rate in phosphoric acid.

Olsen, "Analysis of LPCVD Process Conditions for the Deposition of Low Stress Silicon Nitride", 5 Materials Science in Semiconductor Process 51 (2002) describes a wide range or process conditions that are used to optimize the deposition of low stress silicon nitride films by low-pressure chemical vapor deposition. The results show that an increase in the index of refraction beyond 2.3 by means of increasing the gas flow did not reduce the residual stress appreciably but had a significant detrimental effect on the thickness uniformity and deposition rate.

Taylor et al., "Hexachlorodisilane as a Precursor in the LPCVD of Silicon Dioxide and Silicon Oxynitride Films", 136 J. Electrochem. Soc. 2382 (1989) describes growing films of silicon dioxide and silicon oxynitride by LPCVD using gas-phase mixtures of Si₂Cl₆, N₂, and NH₃ Films of silicon dioxide and silicon oxynitride were grown by LPCVD using gas-phase mixtures of HCDS, N₂O, and NH₃ in the temperature range 600-850°C. The deposited silicon dioxide and silicon oxynitride films exhibited low chlorine content, typically <1% atomic percent.

M. Tanaka et al., "Film Properties of Low-k Silicon Nitride Films Formed by Hexachlorodisilane and Ammonia", 147 J. Electrochem. Soc. 2284 (2000) describes a low-temperature process with good step coverage of silicon nitride (SiN) formed by low-pressure chemical vapor deposition (LPCVD) using hexachlorodisilane (HCD).

JP2000100812 describes a method for depositing a film using SiCl₄ and NH₃ as source gases. The substrate surface may be nitrided using NH₃ prior to deposition. An extremely thin film having an improved insulator property is formed. The silicon nitride film is useful as a capacitor insulator film of a semiconductor integrated circuit.

US Pat. No. 6,355,582 describes a method for forming a silicon nitride film wherein the substrate to be subjected to the film formation is heated, and silicon tetrachloride and ammonia gases are supplied to the substrate heated to a predetermined temperature.

US Pat. No. 10,049,882 describes an atomic layer deposition (ALD) method for fabricating a semiconductor device including the step of forming a dielectric layer on a structure having a height difference. The method includes forming a structure with a height difference on a substrate and forming a dielectric layer structure on the structure. Forming the dielectric layer structure includes forming a first dielectric layer including silicon nitride on the structure with the height difference. Forming the first dielectric layer includes feeding a first gas including pentachlorodisilane (PCDS) or diisopropylamine pentachlorodisilane (DPDC) as a silicon precursor, and a second gas including nitrogen components into a chamber including the substrate such that the first dielectric layer is formed in situ on the structure having the height difference.

PCT Pub. No. WO2018063907 discloses a class of chlorodisilazanes, silicon-heteroatom compounds synthesized therefrom, devices containing the silicon-heteroatom compounds, methods of making the chlorodisilazanes, the silicon-heteroatom compounds, and the devices; and uses of the chlorodisilazanes, silicon-heteroatom compounds, and devices.

PCT Pub. No. WO2018057677 discloses a composition that includes trichlorodisilane as a silicon precursor for use in film forming. The composition includes the silicon precursor compound and at least one of an inert gas, molecular hydrogen, a carbon precursor, nitrogen precursor, and oxygen precursor. The publication also discloses a method of forming a silicon-containing. film on a substrate using the silicon precursor compound and the silicon-containing film formed thereby.

US Pat. No. 9,984,868 discloses cyclical methods of depositing a silicon nitride film on a substrate. In one embodiment such a method includes supplying a halogen silane as a silicon precursor into a reactor; supplying a purge gas to the reactor; and providing an ionized nitrogen precursor into the reactor to react with the substrate and form the silicon nitride film.

US Pub. No. 2009/0155606 discloses cyclical methods of depositing a silicon nitride film on a substrate. In one embodiment a method includes supplying a chlorosilane to a reactor in which a substrate is processed; supplying a purge gas to the reactor; and providing ammonia plasma to the reactor. The method allows a silicon nitride film to be formed at a low process temperature and a high deposition rate. The resulting silicon nitride film has relatively few impurities and a relatively high quality. In addition, a silicon nitride film having good step coverage over features having high aspect ratios and a thin and uniform thickness can be formed. US Pub. No. 2018/033614 A1 discloses a composition and a method for using the composition in the fabrication of an electronic device are disclosed. Compounds, compositions and methods for depositing a low dielectric constant (<4.0) and high oxygen ash resistance silicon-containing film such as, without limitation, a carbon doped silicon oxide, are disclosed. The document discloses the use of partially chlorinated 1,3-disilapropanes as precursors. KR 2018/0010994 A relates to a method for manufacturing a high-purity silicon nitride thin film using plasma atomic layer deposition. Films with improved thin film efficiency are provided and a step coverage by performing a two-stage plasma excitation step. The method can provide a high-purity silicon nitride thin film with an improved deposition rate despite a low film-fanning temperature. As precursors the document discloses silylamines and silazanes. US 2002/0082438 A1 discloses methods for the preparation of organochlorosilanes. The preparation of 1,1,1,3,3-pentachloro-1,3-disilabutane is disclosed therein.

Thus, there is a need to develop a process for forming high quality silicon nitride or carbon-doped silicon nitride using a chemical vapor deposition (CVD) or an atomic layer deposition (ALD) process or an ALD-like process, such as without limitation a cyclic chemical vapor deposition process. One particular application, e.g., O-N-O stack in 3D NAND flash, requires a silicon nitride, silicon oxynitride, or silicon carboxynitride films which exhibit low stress and/or high wet etch rate in phosphoric acid. Further, it may be desirable to develop a low temperature deposition (e.g., deposition at one or more temperatures of about 500 ⁰C or lower) to improve one or more film properties, such as, without limitation, purity and/or density, in a CVD, an ALD, or an ALD-like process.

There is a need in the art to provide a composition and method using the same for depositing silicon nitride or carbon-doped silicon nitride having the following characteristic: a) a carbon content of about 5 atomic % or less, about 3 atomic % or less, about 2 atomic % or less, about 1 atomic % or even less as measured by X-ray photoelectron spectroscopy (XPS), preferably stoichiometric silicon nitride; b) oxygen content of about 5 atomic % or less, about 3 atomic % or less, about 2 atomic % or less, about 1 atomic % or less as measured by X-ray photoelectron spectroscopy (XPS); step coverage of 90 % or higher, 95% or higher, 99% or higher.

### BRIEF SUMMARY OF THE INVENTION

The above-described needs are met in one respect by providing a method as described in the attached claims.

Optionally the resulting silicon nitride or silicon carbon-doped silicon nitride film is then exposed to an oxygen source at one or more temperatures ranging from about ambient temperature to 1000°C, preferably from about 100° to 400°C, to convert the silicon nitride film into a silicon oxynitride film, or to convert the carbon-doped silicon nitride film into a carbon-doped silicon oxynitride film.

### DETAILED DESCRIPTION OF THE INVENTION

Throughout the description, the term "ALD or ALD-like" refers to a process including, but not limited to, the following processes: a) each reactant including silicon precursor and reactive gas is introduced sequentially into a reactor such as a single wafer ALD reactor, semi-batch ALD reactor, or batch furnace ALD reactor; b) each reactant including silicon precursor and reactive gas is exposed to a substrate by moving or rotating the substrate to different sections of the reactor and each section is separated by inert gas curtain, i.e. spatial ALD reactor or roll to roll ALD reactor.

Throughout the description, the term "plasma including/comprising ammonia" refers to a reactive gas or gas mixture generated in situ or remotely via a plasma generator. The gas or gas mixture is selected from the group consisting of ammonia, a mixture of ammonia and helium, a mixture of ammonia and neon, a mixture of ammonia and argon, a mixture of ammonia and nitrogen, a mixture of ammonia and hydrogen, and combinations thereof.

Throughout the description, the term "inert gas plasma" refers to a reactive inert gas or inert gas mixture generated in situ or remotely via a plasma generator. The inert gas or gas mixture is selected from the group consisting of helium, neon, argon, and combination thereof.

Throughout the description, the term "ashing" refers to a process to remove the photoresist or carbon hard mask in semiconductor manufacturing process using a plasma comprising oxygen source such as O₂/inert gas plasma, O₂ plasma, CO₂ plasma, CO plasma, H₂/O₂ plasma or combination thereof.

Throughout the description, the term "damage resistance" refers to film properties after oxygen ashing process. Good or high damage resistance is defined as the following film properties after oxygen ashing: film dielectric constant lower than 6; carbon content in the bulk (at more than 50 Å deep into film) is within 5 at. % as before ashing; less than 50 Å of the film is damaged, observed by differences in dilute HF etch rate between films near surface (less than 50 Å deep) and bulk (more than 50 Å deep).

Throughout the description, the term "alkyl hydrocarbon" refers to a linear or branched C₁ to C₂₀ hydrocarbon, or cyclic C₆ to C₂₀ hydrocarbon. Exemplary hydrocarbons includes but are not limited to, heptane, octane, nonane, decane, dodecane, cyclooctane, cyclononane, and cyclodecane.

Throughout the description, the term "aromatic hydrocarbon" refers to a C₆ to C₂₀ aromatic hydrocarbon. Exemplary aromatic hydrocarbons include, but are not limited to, toluene and mesitylene.

Throughout the description, the term "step coverage" as used herein is defined as a percentage of two thicknesses of the deposited film in a structured or featured substrate having either vias or trenches or both, with bottom step coverage being the ratio (in %): thickness at the bottom of the feature is divided by thickness at the top of the feature, and middle step coverage being the ratio (in %): thickness on a sidewall of the feature is divided by thickness at the top of the feature. Films deposited using the method described herein exhibit a step coverage of about 80% or greater, or about 90% or greater which indicates that the films are conformal.

Throughout the description, the term "plasma comprising ammonia" refers to a reactive gas or gas mixture generated in situ or remotely via a plasma generator. The gas or gas mixture is selected from the group consisting of ammonia, a mixture of ammonia and helium, a mixture of ammonia and neon, a mixture of ammonia and argon, a mixture of ammonia and nitrogen, a mixture of ammonia and hydrogen, nitrogen, a mixture of nitrogen and helium, a mixture of nitrogen and neon, a mixture of nitrogen and argon and combinations thereof.

Throughout the description, the term "plasma including/comprising nitrogen" refers to a reactive gas or gas mixture generated in situ or remotely via a plasma generator. The gas or gas mixture is selected from the group consisting of nitrogen, a mixture of nitrogen and helium, a mixture of nitrogen and neon, a mixture of nitrogen and argon, a mixture of ammonia and nitrogen, a mixture of nitrogen and hydrogen, and combinations thereof.

Described herein are silicon precursor compositions, and methods comprising such compositions, to deposit silicon nitride or carbon-doped silicon nitride having the following characteristics: a) a carbon content of about 5 atomic % or less, about 3 atomic % or less, about 2 atomic % or less, about 1 atomic % or even less as measured by X-ray photoelectron spectroscopy (XPS), preferably stoichiometric silicon nitride; b) oxygen content of about 5 atomic % or less, about 3 atomic % or less, about 2 atomic % or less, about 1 atomic % or less as measured by X-ray photoelectron spectroscopy (XPS); step coverage of 90 % or higher, 95% or higher, or 99% or higher.

The compositions for depositing a silicon-containing film are not part of the present invention. The composition for depositing a silicon-containing film comprises: (a) at least one silicon precursor compound having one or two Si-C-Si linkages selected from the group consisting of 1,1,1,3,3-pentachloro-1,3-disilabutane; and (b) at least one solvent.

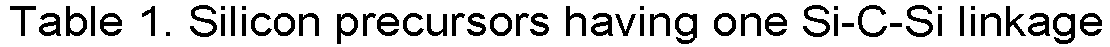

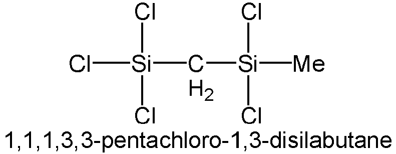

In certain embodiments of the composition described herein, exemplary solvents can include, without limitation, ether, tertiary amine, alkyl hydrocarbon, aromatic hydrocarbon, tertiary aminoether, siloxanes, and combinations thereof. In certain embodiments, the difference between the boiling point of the compound having one SiC-Si or two Si-C-Si linkages and the boiling point of the solvent is 40°C or less. The wt % of silicon precursor compound in the solvent can vary from 1 to 99 wt %, or 10 to 90 wt%, or 20 to 80 wt %, or 30 to 70 wt %, or 40 to 60 wt %, to 50 to 50 wt %. In some embodiments, the composition can be delivered via direct liquid injection into a reactor chamber for silicon-containing film using conventional direct liquid injection equipment and methods. In one embodiment of the method described herein, the silicon nitride or carbon-doped silicon nitride film has a carbon content less than 5 at. % or less and deposited using a plasma enhanced ALD process.

In certain embodiments, the method described herein further comprises:
f. optionally post-deposition treating the silicon nitride or carbon-doped silicon nitride film carbon-doped film with a thermal anneal or a spike anneal at temperatures from 400 to 1000C or a UV light source. In this or other embodiments, the UV exposure step can be carried out either during film deposition, or once deposition has been completed.
g. optionally providing post-deposition exposing the carbon-doped silicon nitride film to a plasma comprising hydrogen or inert gas or nitrogen to improve at least one of the films' physical properties

In certain embodiments, the method described herein further comprises:
f. optionally post-deposition treating the silicon nitride or carbon-doped silicon nitride film with a spike anneal at temperatures from 400 to 1000C or a UV light source. In this or other embodiments, the UV exposure step can be carried out either during film deposition, or once deposition has been completed;
g. optionally providing post-deposition exposing the silicon nitride or carbon-doped silicon nitride film to a plasma comprising hydrogen or inert gas or nitrogen to improve at least one of the films' physical properties.

In certain embodiments, the method described herein further comprises;
f. providing post-deposition treating the silicon nitride or carbon-doped silicon nitride film with an oxygen source at one or more temperatures ranging from about ambient temperature to 1000°C or from about 100° to 400°C to convert the silicon nitride or carbon-doped silicon nitride film into a carbon-doped silicon oxynitride film either in situ or in another chamber.

In one embodiment, the substrate includes at least one feature wherein the feature comprises a pattern trench with an aspect ratio of 1:9 or more, and an opening of 180 nm or less.

In yet another embodiment that is not part of the present invention, a vessel for depositing a silicon-containing film includes one or more silicon precursor compounds described herein. In one particular embodiment, the vessel is at least one pressurizable vessel (preferably of stainless steel having a design such as disclosed in U.S. Patent Nos. US7334595; US6077356; and US5069244. The container can comprise either glass (borosilicate or quartz glass) or type 316, 316L, 304 or 304L stainless steel alloys (UNS designation S31600, S31603, S30400 S30403) fitted with the proper valves and fittings to allow the delivery of one or more precursors to the reactor for a CVD or an ALD process. In this or other embodiments, the silicon precursor is provided in a pressurizable vessel comprised of stainless steel and the purity of the precursor is 98% by weight or greater or 99.5% or greater which is suitable for the semiconductor applications. The silicon precursor compounds are preferably substantially free of metal ions such as, Al³⁺ ions, Fe²⁺, Fe³⁺, Ni²⁺, Cr³⁺. As used herein, the term "substantially free" as it relates to Al, Fe, Ni Cr means less than about 5 ppm (by weight) as measured by ICP-MS, preferably less than about 1 ppm, and more preferably less than about 0.1 ppm as measured by ICP-MS, and most preferably about 0.05 ppm as measured by ICP-MS. In certain embodiments, such vessels can also have means for mixing the precursors with one or more additional precursor if desired. In these or other embodiments, the contents of the vessel(s) can be premixed with an additional precursor. Alternatively, the silicon precursor is and/or other precursor can be maintained in separate vessels or in a single vessel having separation means for maintaining the silicon precursor is and other precursor separate during storage.

The silicon-containing film is deposited upon at least a surface of a substrate such as a semiconductor or display substrate. In the method described herein, the substrate may be comprised of and/or coated with a variety of materials well known in the art including films of silicon such as crystalline silicon or amorphous silicon, silicon oxide, silicon nitride, amorphous carbon, silicon oxycarbide, silicon oxynitride, silicon carbide, germanium, germanium doped silicon, boron doped silicon, metal such as copper, tungsten, aluminum, cobalt, nickel, tantalum), metal nitride such as titanium nitride, tantalum nitride, metal oxide, group III/V metals or metalloids such as GaAs, InP, GaP and GaN, AMOLED (active matrix organic light-emitting diode) flexible substrates (for example plastic substrates) and a combination thereof. These coatings may completely coat the semi-conductor substrate, may be in multiple layers of various materials and may be partially etched to expose underlying layers of material. The surface may also have on it a photoresist material that has been exposed with a pattern and developed to partially coat the substrate. In certain embodiments, the semiconductor substrate comprising at least one surface feature selected from the group consisting of pores, vias, trenches, and combinations thereof. The potential application of the silicon-containing films include but not limited to low k spacer for FinFET or nanosheet, sacrificial hard mask for self-aligned patterning process (such as SADP, SAQP, or SAOP).

The deposition method used to form the silicon-containing films or coatings are deposition processes. As used herein, the term "chemical vapor deposition processes" refers to any process wherein a substrate is exposed to one or more volatile precursors, which react and/or decompose on the substrate surface to produce the desired deposition. As used herein, the term "atomic layer deposition process" refers to a self-limiting (e.g., the amount of film material deposited in each reaction cycle is constant), sequential surface chemistry that deposits films of materials onto substrates of varying compositions. As used herein, the term "thermal atomic layer deposition process" refers to atomic layer deposition process at substrate temperatures ranging from room temperature to 600°C without in situ or remote plasma. Although the precursors, reagents and sources used herein may be sometimes described as "gaseous", it is understood that the precursors can be either liquid or solid which are transported with or without an inert gas into the reactor via direct vaporization, bubbling or sublimation. In some case, the vaporized precursors can pass through a plasma generator.

The silicon-containing film is deposited using an ALD process. In a further embodiment, the silicon-containing film is deposited using a thermal ALD process. The term "reactor" as used herein, includes without limitation, reaction chamber or deposition chamber.

In certain embodiments, the method disclosed herein avoids pre-reaction of precursor(s) by using ALD methods that separate the precursor(s) prior to and/or during the introduction to the reactor. Deposition techniques such as ALD or CCVD processes are preferably used to deposit the silicon-containing film. In one embodiment, the film is deposited via an ALD process in a typical single wafer ALD reactor, semi-batch ALD reactor, or batch furnace ALD reactor by exposing the substrate surface alternatively to the one or more silicon-containing precursors, oxygen source, nitrogen-containing source, or other precursors or reagents. Film growth proceeds by self-limiting control of the surface reaction, the pulse length of each precursor or reagent, and the deposition temperature. However, once the surface of the substrate is saturated, the film growth ceases. In another embodiment, each reactant including the silicon precursor and reactive gas is exposed to a substrate by moving or rotating the substrate to different sections of the reactor and each section is separated by an inert gas curtain, i.e. a spatial ALD reactor or a roll to roll ALD reactor.

Depending upon the deposition method, in certain embodiments, the silicon precursors described herein and optionally other silicon-containing precursors may be introduced into the reactor at a predetermined molar volume, such as from about 0.1 to about 1000 micromoles. In this or other embodiments, the precursor may be introduced into the reactor for a predetermined time period. In certain embodiments, the time period ranges from about 0.001 to about 500 seconds.

In certain embodiments, the silicon nitride or carbon-doped silicon films deposited using the methods described herein are treated with an oxygen source, reagent or precursor comprising oxygen, e.g. water vapor, to convert such films into carbon-doped oxynitride. An oxygen source may be introduced into the reactor in the form of at least one oxygen source and/or may be present incidentally in the other precursors used in the deposition process. Suitable oxygen source gases may include, for example, air, water (H₂O) (e.g., deionized water, purified water, distilled water, water vapor, water vapor plasma, hydrogen peroxide, oxygenated water, air, a composition comprising water and other organic liquid), oxygen (O₂), oxygen plasma, ozone (O₃), nitric oxide (NO), nitrogen dioxide (NO₂), nitrous oxide (N₂O), carbon monoxide (CO), hydrogen peroxide (H₂O₂), a plasma comprising water, a plasma comprising water and argon, hydrogen peroxide, a composition comprising hydrogen, a composition comprising hydrogen and oxygen, carbon dioxide (CO₂), air, and combinations thereof. In certain embodiments, the oxygen source comprises an oxygen source gas that is introduced into the reactor at a flow rate ranging from about 1 to about 10000 square cubic centimeters (sccm) or from about 1 to about 1000 sccm. The oxygen source can be introduced for a time that ranges from about 0.1 to about 100 seconds. The catalyst is selected from a Lewis base such as pyridine, piperazine, trimethylamine, tert-butylamine, diethylamine, trimethylamine, ethylenediamine, ammonia, or other organic amines.

In embodiments wherein the film is deposited by an ALD or a cyclic CVD process, the precursor pulse can have a pulse duration that is greater than 0.01 seconds, and the oxygen source can have a pulse duration that is less than 0.01 seconds, while the water pulse duration can have a pulse duration that is less than 0.01 seconds.

In certain embodiments, the oxygen source is continuously flowing into the reactor while precursor pulse and plasma are introduced in sequence. The precursor pulse can have a pulse duration greater than 0.01 seconds while the plasma duration can range between 0.01 seconds to 100 seconds.

The silicon-containing films comprise silicon and nitrogen. The silicon-containing films deposited using the methods described herein are formed in the presence of a nitrogen-containing source. A nitrogen-containing source may be introduced into the reactor in the form of at least one nitrogen source gas and/or may be present incidentally in the other precursors used in the deposition process.

Suitable ammonia-containing gases may include, for example, ammonia, a mixture of ammonia and inert gas, a mixture of ammonia and nitrogen, a mixture of ammonia and hydrogen, and combinations thereof.

In certain embodiments, the nitrogen source is introduced into the reactor at a flow rate ranging from about 1 to about 10000 square cubic centimeters (sccm) or from about 1 to about 1000 sccm. The nitrogen-containing source can be introduced for a time that ranges from about 0.1 to about 100 seconds. In embodiments wherein the film is deposited by an ALD or a cyclic CVD process using both a nitrogen and oxygen source, the precursor pulse can have a pulse duration that is greater than 0.01 seconds, and the nitrogen source can have a pulse duration that is less than 0.01 seconds, while the water pulse duration can have a pulse duration that is less than 0.01 seconds. In yet another embodiment, the purge duration between the pulses that can be as low as 0 seconds or is continuously pulsed without a purge in-between.

The deposition methods disclosed herein include one or more steps of purging unwanted or unreacted material from a reactor using purge gases. The purge gas, which is used to purge away unconsumed reactants and/or reaction byproducts, is an inert gas that does not react with the precursors. Exemplary purge gases include, but are not limited to, argon (Ar), nitrogen (N₂), helium (He), neon (Ne), hydrogen (H₂), and combinations thereof. In certain embodiments, a purge gas such as Ar is supplied into the reactor at a flow rate ranging from about 10 to about 10000 sccm for about 0.1 to 1000 seconds, thereby purging the unreacted material and any byproduct that may remain in the reactor.

The respective steps of supplying the precursors, oxygen source, the ammonia-containing source, and/or other precursors, source gases, and/or reagents may be performed by changing the time for supplying them to change the stoichiometric composition of the resulting film.

Energy is applied to the at least one of the precursor, ammonia-containing source, reducing agent such as hydrogen plasma, other precursors or combination thereof to induce reaction and to form the film or coating on the substrate. Such energy can be provided by, but not limited to, thermal, plasma, pulsed plasma, helicon plasma, high density plasma, inductively coupled plasma, X-ray, e-beam, photon, remote plasma methods, and combinations thereof.

In certain embodiments, a secondary RF frequency source can be used to modify the plasma characteristics at the substrate surface. In embodiments wherein the deposition involves plasma, the plasma-generated process may comprise a direct plasma-generated process in which plasma is directly generated in the reactor, or alternatively a remote plasma-generated process in which plasma is generated outside of the reactor and supplied into the reactor.

The silicon precursors and/or other silicon-containing precursors may be delivered to the reaction chamber, such as a CVD or ALD reactor, in a variety of ways. In one embodiment, a liquid delivery system may be utilized. In an alternative embodiment, a combined liquid delivery and flash vaporization process unit may be employed, such as, for example, the turbo vaporizer manufactured by MSP Corporation of Shoreview, MN, to enable low volatility materials to be volumetrically delivered, which leads to reproducible transport and deposition without thermal decomposition of the precursor. In liquid delivery formulations, the precursors described herein may be delivered in neat liquid form, or alternatively, may be employed in solvent formulations or compositions comprising same. Thus, in certain embodiments the precursor formulations may include solvent component(s) of suitable character as may be desirable and advantageous in a given end use application to form a film on a substrate.

In this or other embodiments, it is understood that the steps of the methods described herein may be performed in a variety of orders, may be performed sequentially or concurrently (e.g., during at least a portion of another step), and any combination thereof. The respective step of supplying the precursors and the nitrogen-containing source gases may be performed by varying the duration of the time for supplying them to change the stoichiometric composition of the resulting silicon-containing film.

In a still further embodiment of the methods described herein, the film or the as-deposited film is subjected to a treatment step. The treatment step can be conducted during at least a portion of the deposition step, after the deposition step, and combinations thereof. Exemplary treatment steps include, without limitation, treatment via high temperature thermal annealing; plasma treatment; ultraviolet (UV) light treatment; laser; electron beam treatment and combinations thereof to affect one or more properties of the film. The films deposited with the silicon precursors having one or two Si-C-Si linkages described herein, when compared to films deposited with previously disclosed silicon precursors under the same conditions, have improved properties such as, without limitation, a wet etch rate that is lower than the wet etch rate of the film before the treatment step or a density that is higher than the density prior to the treatment step. In one particular embodiment, during the deposition process, as-deposited films are intermittently treated. These intermittent or mid-deposition treatments can be performed, for example, after each ALD cycle, after a certain number of ALD, such as, without limitation, one (1) ALD cycle, two (2) ALD cycles, five (5) ALD cycles, or after every ten (10) or more ALD cycles.

In an embodiment wherein the film is treated with a high temperature annealing step, the annealing temperature is at least 100°C or greater than the deposition temperature. In this or other embodiments, the annealing temperature ranges from about 400°C to about 1000°C. In this or other embodiments, the annealing treatment can be conducted in a vacuum (< 760 Torr), inert environment or in oxygen containing environment (such as ozone, H₂O, H₂O₂, N₂O, NO₂ or O₂)

In an embodiment wherein the film is treated to UV treatment, film is exposed to broad band UV or, alternatively, an UV source having a wavelength ranging from about 150 nanometers (nm) to about 400 nm. In one particular embodiment, the as-deposited film is exposed to UV in a different chamber than the deposition chamber after a desired film thickness is reached.

In an embodiment where in the film is treated with a plasma, passivation layer such as carbon-doped silicon oxide is deposited to prevent chlorine and nitrogen contamination from penetrating film in the subsequent plasma treatment. The passivation layer can be deposited using atomic layer deposition or cyclic chemical vapor deposition.

In an embodiment wherein the film is treated with a plasma, the plasma source is selected from the group consisting of hydrogen plasma, plasma comprising hydrogen and helium, plasma comprising hydrogen and argon. Hydrogen plasma lowers film dielectric constant and boost the damage resistance to following plasma ashing process while still keeping the carbon content in the bulk almost unchanged.

The following examples illustrate certain aspects of the instant invention and do not limit the scope of the appended claims.

### EXAMPLES

In the following examples, unless stated otherwise, properties will be obtained from sample films that are deposited onto silicon wafer with resistivity of 5-20 Ω-cm as substrate. All film depositions are performed using the CN-1 reactor has showerhead design with 13.56 MHz direct plasma.

In typical process conditions, unless stated otherwise, the chamber pressure is fixed at a pressure ranging from about 1 to about 5 Torr. Additional inert gas is used to maintain chamber pressure.

The film depositions comprise the steps listed in Tables 3, 4, and 5 for plasma enhanced ALD. Unless otherwise specified, a total of 100 or 200 or 300 or 500 deposition cycles are used to get the desired film thickness.

**Table 3. Deposition Steps in PEALD Silicon Nitride or Carbon-doped Silicon Nitride Films**

| Step | |
|---|---|
| a | Provide a substrate comprising a surface feature in a reactor and heat the substrate to a desired temperature |
| b | Introduce vapors of a silicon precursor to the reactor; additional inert gas is used to maintain chamber pressure to provide a chemisorbed layer |
| c | Purge unreacted the silicon precursor from the reactor chamber with inert gas |
| d | Introduce a plasma comprising an ammonia source to react with the surface of the chemisorbed layer and create reactive sites |
| e | Purge reaction by-products out |

**Table 4. Deposition Steps in PEALD Silicon Nitride or Carbon-doped Silicon Nitride Films**

| Step | |
|---|---|
| a | Provide a substrate comprising a surface feature in a reactor and heat the substrate to a desired temperature |
| b | Introduce vapors of a silicon precursor to the reactor; additional inert gas is used to maintain chamber pressure to provide a chemisorbed layer |
| c | Purge unreacted silicon precursor from the reactor chamber with inert gas |
| d | Introduce a first plasma comprising an ammonia source to react with the surface of the chemisorbed layer and create reactive sites |
| e | Purge reaction by-products out |
| f | Introduce a second plasma comprising a nitrogen source to react with the surface of the chemisorbed layer and create reactive sites |
| g | Purge reaction by-products out |

**Table 5: Deposition Steps in PEALD Silicon Nitride or Carbon-doped Silicon Nitride Films**

| Step | |
|---|---|
| a | Provide a substrate comprising a surface feature in a reactor and heat the substrate to a desired temperature |
| b | Introduce vapors of a silicon precursor to the reactor; additional inert gas is used to maintain chamber pressure to provide a chemisorbed layer |
| c | Purge unreacted silicon precursor from the reactor chamber with inert gas |
| d | Introduce a first plasma comprising a nitrogen source to react with the surface of the chemisorbed layer and create reactive sites |
| e | Purge reaction by-products out |
| f | Introduce a second plasma comprising an ammonia source to react with the surface of the chemisorbed layer and create reactive sites |
| g | Purge reaction by-products out |

The refractive index (RI) and thickness for the deposited films are measured using an ellipsometer. Film non-uniformity is calculated using the standard equation: % non-uniformity = ((max thickness - min thickness)/(2*average (avg) thickness)). Film structure and composition are analyzed using Fourier Transform Infrared (FTIR) spectroscopy and X-Ray Photoelectron Spectroscopy (XPS). The density for the films is measured with X-ray Reflectometry (XRR).

### Example 1: ALD silicon nitride using 1,1,1,3,3-pentachloro-1,3-disilabutane and NH₃/argon plasma

A silicon wafer was loaded into a CN-1 reactor equipped with a showerhead design with 13.56 MHz direct plasma with a chamber pressure of 1 torr. 1,1,1,3,3-pentachloro-1,3-disilabutane as a silicon precursor, was delivered as vapors into the reactor using bubbling or vapor draw.

The ALD cycle was comprised of the process steps provided in Table 3 and used the following process parameters:
a. Provide a substrate in a reactor and heat the substrate to about 300°C
b. Introduce vapors of 1,1,1,3,3-pentachloro-1,3-disilabutane to the reactor
   Argon flow: 100 sccm through precursor container
   Pulse: 2 seconds
   Ar flow: 1000 sccm
c. Purge
   Argon flow: 1000 sccm
   Purge time: 10 seconds
d. Introduce ammonia plasma
   Argon flow: 1000 sccm
   Ammonia flow: 300 sccm
   Plasma power; 300 W
   Pulse: 15 seconds
e. Purge
   Argon flow: 1000 sccm
   Purge time: 5 seconds
Steps b to e were repeated for 1000 cycles to provide 32nm of silicon nitride with a composition of 58.66 at. % nitrogen, 38.96 at. % silicon, and 2.37 at. % oxygen. Both chlorine and carbon were undetectable. The refractive index was about 1.9.

### Example 2: ALD silicon nitride using 1,1,1,3,3-pentachloro-1,3-disilabutane and NH₃/argon plasma

A silicon wafer was loaded into the CN-1 reactor equipped with showerhead design with 13.56 MHz direct plasma with chamber pressure of 1 torr. 1,1,1,3,3-pentachloro-1,3-disilabutane was delivered as vapors into the reactor using bubbling.

The ALD cycle was comprised of the process steps provided in Table 1 and used the following process parameters:
a) Provide a substrate in a reactor and heat the substrate to about 400°C;
b) Introduce vapors of 1,1,1,3,3-pentachloro-1,3-disilabutane to the reactor;
   Argon flow: 100 sccm through precursor container
   Pulse: 2 seconds
   Argon: 1000 sccm
c) Inert gas purge
   Argon flow: 1000 sccm
   Purge time: 15 seconds
d) Introduce ammonia plasma
   Argon flow: 1000 sccm
   Ammonia flow: 50 sccm
   Plasma power: 300 W
   Pulse: 10 seconds
e) Purge
   Argon flow: 1000 sccm
   Purge time: 10 seconds

Steps b to e were repeated for 1000 cycles to provide 26nm of silicon nitride with a composition of 58.30 at. % nitrogen, 39.15 at. % silicon, 2.55 at. % oxygen. Both chlorine and carbon were undetectable as measured by XPS. The composition of the resulting film in this working example was close to stoichiometric silicon nitride. The refractive index was about 1.9.

Although illustrated and described above with reference to certain specific embodiments and working examples, the present invention is nevertheless not intended to be limited to the details shown. It is expressly intended, for example, that all ranges broadly recited in this document include within their scope all narrower ranges which fall within the broader ranges.

## Claims

1. A method for forming a silicon nitride or carbon-doped silicon nitride via a plasma enhanced ALD process, the method comprising:
a) providing a substrate comprising a surface feature in a reactor and heating the reactor to one or more temperatures ranging up to 600°C, and optionally maintaining the reactor at a pressure of 100 torr or less;
b) introducing into the reactor at least one silicon precursor whereby the silicon precursor reacts on at least a portion of the surface feature of the substrate to provide a chemisorbed layer;
c) purging the reactor of any unreacted silicon precursors and/or any reaction by-products using inert gas;
d) providing a plasma comprising an ammonia source into the reactor to react with the chemisorbed layer to form a silicon nitride film; and
e) purging the reactor of any further reaction by-products with inert gas;
wherein the steps b through e are repeated until a desired thickness of the silicon nitride film is deposited,
wherein the at least one silicon precursor is 1,1,1,3,3-pentachloro-1,3-disilabutane and in that the film formed has a dielectric constant (k) of 6 or less, and a carbon content of 5 atomic weight % or less as measured by X-ray photoelectron spectroscopy.

2. The method according to claim 1, wherein the silicon nitride film is a carbon-doped silicon nitride film.

3. The method according to claim 1, further comprising:
treating the silicon nitride film with a spike anneal at a temperature ranging between 400 and 1000°C.

4. The method according to claim 1, further comprising:
exposing the silicon nitride film to a UV light source either during or after deposition of the silicon nitride film.

5. The method according to claim 1, further comprising:
exposing the silicon nitride film to a plasma comprising one or more gases selected from the group consisting of hydrogen, inert gas, nitrogen, and combinations thereof.

6. The method according to claim 1, further comprising:
treating the silicon nitride film with an oxygen source at one or more temperatures ranging from ambient temperature to 1000 °C to convert the silicon nitride into a silicon oxynitride film, either in situ or in a separate chamber from the reactor.

7. The method according to claim 6, wherein the silicon nitride film is a carbon-doped silicon nitride film, and wherein the step of treating the silicon nitride film with an oxygen source converts the carbon-doped silicon nitride into a carbon-doped silicon oxynitride film.

8. The method according to claim 1, wherein the film formed has
a carbon content of about 3 atomic weight percent or less as measured by X-ray photoelectron spectroscopy; or
a carbon content of about 2 atomic weight percent or less as measured by X-ray photoelectron spectroscopy; or
a carbon content of about 1 atomic weight percent or less as measured by X-ray photoelectron spectroscopy.

9. The method of claim 1 further comprising performing a thermal anneal on the silicon nitride or carbon-doped silicon nitride film at temperatures from 300 to 1000°C.

10. The method of claim 1, 2, 6 or 7 further comprising performing a plasma treatment on the silicon nitride film, the carbon-doped silicon nitride film, the silicon oxynitride film, or the carbon-doped silicon oxynitride film with an inert gas plasma or hydrogen/inert plasma or nitrogen plasma at a temperature ranging between 25°C and 600°C.

11. A method for forming a silicon nitride or carbon-doped silicon nitride via a plasma enhanced ALD process according to claim 1,
wherein step d) comprises providing a first plasma source into the reactor to react with the chemisorbed layer to form a silicon nitride film that is optionally carbon-doped;
and the method additionally comprises the following steps:
f) providing a second plasma source into the reactor to further react and form the silicon nitride film that is optionally carbon-doped;
g) purging the reactor of any further reaction by-products using inert gas;
wherein the steps b through g are repeated until the silicon nitride film that is optionally carbon-doped reaches a desired thickness, and wherein the reactor is maintained at one or more temperatures ranging from 25°C to 600°C and
wherein the plasma is a plasma comprising an ammonia source and the second plasma is a plasma comprising a nitrogen source or
wherein the first plasma is a plasma comprising a nitrogen source and the second plasma is a plasma comprising an ammonia source.

12. The method according to claim 1 or 11, wherein the film formed is suitable for semiconductor industry or display applications.

## Patentansprüche

1. Verfahren zur Herstellung von Siliziumnitrid oder kohlenstoffdotiertem Siliziumnitrid mittels eines plasmaunterstützten ALD-Prozesses, das Verfahren umfassend:
a) Bereitstellen eines Substrats mit einer Oberflächenstruktur in einem Reaktor und Erhitzen des Reaktors auf eine oder mehrere Temperaturen bis zu 600 °C und gegebenenfalls Halten des Reaktors bei einem Druck von 100 Torr oder weniger;
b) Einbringen mindestens eines Siliziumvorläufers in den Reaktor, wobei der Siliziumvorläufer auf mindestens einem Teil der Oberflächenstruktur des Substrats reagiert, um eine chemisorbierte Schicht zu bilden;
c) Reinigung des Reaktors von nicht umgesetzten Siliziumvorläufern und/oder Reaktionsnebenprodukten unter Verwendung von Inertgas;
d) Bereitstellen eines Plasmas, das eine Ammoniakquelle umfasst, in dem Reaktor, um mit der chemisorbierten Schicht zu reagieren und einen Siliziumnitridfilm zu bilden; und
e) den Reaktor mit Inertgas von weiteren Reaktionsnebenprodukten reinigen;
wobei die Schritte b bis e wiederholt werden, bis eine gewünschte Dicke des Siliziumnitridfilms abgeschieden ist,
wobei, der mindestens eine Siliziumvorläufer 1,1,1,3,3-Pentachlor-1,3-disilabutan ist und dass der gebildete Film eine Dielektrizitätskonstante (k) von 6 oder weniger und einen Kohlenstoffgehalt von 5 Atomgewichtsprozent oder weniger, gemessen mittels Röntgenphotoelektronenspektroskopie, aufweist.

2. Das Verfahren nach Anspruch 1, wobei der Siliziumnitridfilm ein mit Kohlenstoff dotierter Siliziumnitridfilm ist.

3. Das Verfahren nach Anspruch 1, ferner umfassend:
Behandeln des Siliziumnitridfilms mit Spitzen-Temperung bei einer Temperatur zwischen 400 und 1000 °C.

4. Das Verfahren nach Anspruch 1, ferner umfassend:
Aussetzen des Siliziumnitridfilms einer UV-Lichtquelle entweder während oder nach der Abscheidung des Siliziumnitridfilms.

5. Das Verfahren nach Anspruch 1, ferner umfassend:
Aussetzen des Siliziumnitridfilms einem Plasma, das ein oder mehrere Gase umfasst, die aus der Gruppe ausgewählt sind, die aus Wasserstoff, Inertgas, Stickstoff und Kombinationen davon besteht.

6. Das Verfahren nach Anspruch 1, ferner umfassend:
Behandeln des Siliziumnitridfilms mit einer Sauerstoffquelle bei einer oder mehreren Temperaturen im Bereich von Umgebungstemperatur bis 1000 °C, um das Siliziumnitrid in einen Siliziumoxynitridfilm umzuwandeln, entweder in situ oder in einer vom Reaktor getrennten Kammer.

7. Das Verfahren nach Anspruch 6, wobei der Siliziumnitridfilm ein mit Kohlenstoff dotierter Siliziumnitridfilm ist und wobei der Schritt des Behandelns des Siliziumnitridfilms mit einer Sauerstoffquelle das mit Kohlenstoff dotierte Siliziumnitrid in einen mit Kohlenstoff dotierten Siliziumoxynitridfilm umwandelt.

8. Das Verfahren nach Anspruch 1, wobei der gebildete Film
einen Kohlenstoffgehalt von etwa 3 Atomgewichtsprozent oder weniger, gemessen mittels Röntgenphotoelektronenspektroskopie, oder
einen Kohlenstoffgehalt von etwa 2 Atomgewichtsprozent oder weniger, gemessen mittels Röntgenphotoelektronenspektroskopie, oder
einen Kohlenstoffgehalt von etwa 1 Atomgewichtsprozent oder weniger, gemessen mittels Röntgenphotoelektronenspektroskopie, aufweist.

9. Das Verfahren nach Anspruch 1, das ferner das Durchführen eines thermischen Temperns des Siliziumnitrid- oder kohlenstoffdotierten Siliziumnitridfilms bei Temperaturen von 300 bis 1000 °C umfasst.

10. Das Verfahren nach Anspruch 1, 2, 6 oder 7, das ferner das Durchführen einer Plasmabehandlung an dem Siliziumnitridfilm, dem kohlenstoffdotierten Siliziumnitridfilm, dem Siliziumoxynitridfilm oder dem kohlenstoffdotierten Siliziumoxynitridfilm mit einem Inertgasplasma oder einem Wasserstoff/Inertplasma oder einem Stickstoffplasma bei einer Temperatur im Bereich zwischen 25 °C und 600 °C umfasst.

11. Verfahren zur Herstellung von Siliziumnitrid oder kohlenstoffdotiertem Siliziumnitrid mittels eines plasmaunterstützten ALD-Prozesses gemäß Anspruch 1,
wobei Schritt d) das Bereitstellen einer ersten Plasmaquelle in den Reaktor umfasst, um mit der chemisorbierten Schicht zu reagieren und einen Siliziumnitridfilm zu bilden, der optional mit Kohlenstoff dotiert ist;
und das Verfahren zusätzlich die folgenden Schritte umfassend:
f) Bereitstellen einer zweiten Plasmaquelle in den Reaktor, um die Reaktion fortzusetzen und den Siliziumnitridfilm zu bilden, der optional mit Kohlenstoff dotiert ist;
g) den Reaktor mit Inertgas von weiteren Reaktionsnebenprodukten reinigen;
wobei die Schritte b bis g wiederholt werden, bis der gegebenenfalls mit Kohlenstoff dotierte Siliziumnitridfilm eine gewünschte Dicke erreicht, und wobei der Reaktor auf einer oder mehreren Temperaturen im Bereich von 25 °C bis 600 °C gehalten wird, und
wobei das Plasma ein Plasma ist, das eine Ammoniakquelle umfasst, und das zweite Plasma ein Plasma ist, das eine Stickstoffquelle umfasst, oder
wobei das erste Plasma ein Plasma ist, das eine Stickstoffquelle umfasst, und das zweite Plasma ein Plasma ist, das eine Ammoniakquelle umfasst.

12. Das Verfahren nach Anspruch 1 oder 11, wobei der gebildete Film für Anwendungen in der Halbleiterindustrie oder für Displayanwendungen geeignet ist.

## Revendications

1. Procédé de formation d'un nitrure de silicium ou d'un nitrure de silicium dopé au carbone par un procédé ALD activé par plasma, le procédé comprenant :
a) fournir un substrat comprenant une caractéristique de surface dans un réacteur et chauffer le réacteur jusqu'à une ou plusieurs températures allant jusqu'à 600 °C, et éventuellement maintenir le réacteur à une pression de 100 torr ou moins ;
b) introduire dans le réacteur au moins un précurseur de silicium, le précurseur de silicium réagissant sur au moins une partie de la caractéristique de surface du substrat pour former une couche chimisorbée ;
c) purger le réacteur de tout précurseur de silicium n'ayant pas réagi et/ou de tout sous-produit de réaction à l'aide d'un gaz inerte ;
d) introduire un plasma comprenant une source d'ammoniac dans le réacteur pour réagir avec la couche chimisorbée pour former un film de nitrure de silicium ; et
e) purger le réacteur de tout autre sous-produit de réaction avec un gaz inerte ;
dans lequel les étapes b à e sont répétées jusqu'à ce qu'une épaisseur souhaitée du film de nitrure de silicium soit déposée,
dans lequel le ou les précurseurs de silicium sont le 1,1,1,3,3-pentachloro-1,3-disilabutane et en ce que le film formé a une constante diélectrique (k) de 6 ou moins, et une teneur en carbone de 5 % en poids atomique ou moins telle que mesurée par spectroscopie photoélectronique à rayons X.

2. Procédé selon la revendication 1, dans lequel le film de nitrure de silicium est un film de nitrure de silicium dopé au carbone.

3. Procédé selon la revendication 1, comprenant en outre :
un traitement du film de nitrure de silicium par un recuit de pointe à une température dans la plage entre 400 et 1 000 °C.

4. Procédé selon la revendication 1, comprenant en outre :
une exposition du film de nitrure de silicium à une source de lumière UV pendant ou après le dépôt du film de nitrure de silicium.

5. Procédé selon la revendication 1, comprenant en outre :
une exposition du film de nitrure de silicium à un plasma comprenant un ou plusieurs gaz sélectionnés dans le groupe constitué par l'hydrogène, un gaz inerte, l'azote et des combinaisons de ceux-ci.

6. Procédé selon la revendication 1, comprenant en outre :
un traitement du film de nitrure de silicium avec une source d'oxygène à une ou plusieurs températures dans la plage entre la température ambiante et 1 000 °C afin de convertir le nitrure de silicium en un film d'oxynitrure de silicium, soit *in situ,* soit dans une chambre séparée du réacteur.

7. Procédé selon la revendication 6, dans lequel le film de nitrure de silicium est un film de nitrure de silicium dopé au carbone, et dans lequel l'étape de traitement du film de nitrure de silicium avec une source d'oxygène convertit le nitrure de silicium dopé au carbone en un film d'oxynitrure de silicium dopé au carbone.

8. Procédé selon la revendication 1, dans lequel le film formé a
une teneur en carbone d'environ 3 pour cent en poids atomique ou moins telle que mesurée par spectroscopie photoélectronique à rayons X ; ou
une teneur en carbone d'environ 2 pour cent en poids atomique ou moins telle que mesurée par spectroscopie photoélectronique à rayons X ; ou
une teneur en carbone d'environ 1 pour cent en poids atomique ou moins telle que mesurée par spectroscopie photoélectronique à rayons X.

9. Procédé selon la revendication 1, comprenant en outre la réalisation d'un recuit de pointe sur le film de nitrure de silicium ou de nitrure de silicium dopé au carbone à des températures de 300 à 1 000 °C.

10. Procédé selon la revendication 1, 2, 6 ou 7, comprenant en outre la réalisation d'un traitement au plasma sur le film de nitrure de silicium, le film de nitrure de silicium dopé au carbone, le film d'oxynitrure de silicium ou le film d'oxynitrure de silicium dopé au carbone avec un plasma de gaz inerte ou un plasma d'hydrogène/inerte ou un plasma d'azote à une température dans la plage entre 25 °C et 600 °C.

11. Procédé de formation d'un nitrure de silicium ou d'un nitrure de silicium dopé au carbone par un procédé ALD activé par plasma selon la revendication 1,
dans lequel l'étape d) comprend l'introduction d'une première source de plasma dans le réacteur pour réagir avec la couche chimisorbée pour former un film de nitrure de silicium qui est éventuellement dopé au carbone ;
et le procédé comprend de plus les étapes suivantes :
f) fournir une seconde source de plasma dans le réacteur pour réagir davantage et former le film de nitrure de silicium qui est éventuellement dopé au carbone ;
g) purger le réacteur de tout autre sous-produit de réaction à l'aide d'un gaz inerte ;
dans lequel les étapes b à g sont répétées jusqu'à ce que le film de nitrure de silicium éventuellement dopé au carbone atteigne une épaisseur souhaitée, et dans lequel le réacteur est maintenu à une ou plusieurs températures comprises dans la plage de 25 °C à 600 °C et
dans lequel le plasma est un plasma comprenant une source d'ammoniac et le second plasma est un plasma comprenant une source d'azote ou
dans lequel le premier plasma est un plasma comprenant une source d'azote et le second plasma est un plasma comprenant une source d'ammoniac.

12. Procédé selon la revendication 1 ou 11, dans lequel le film formé est approprié pour l'industrie des semiconducteurs ou des applications d'affichage.
